Europäisches Patentamt

(19) European Patent Office

Office européen des brevets

(11) Numéro de publication : **0 132 196**
**B1**

(12) # FASCICULE DE BREVET EUROPÉEN

(45) Date de publication du fascicule du brevet :
30.09.87

(51) Int. Cl.⁴ : **H 03 L 7/18, H 04 N 9/45**

(21) Numéro de dépôt : **84401461.3**

(22) Date de dépôt : **10.07.84**

(54) Synthétiseur de fréquence pour téléviseur.

(30) Priorité : **19.07.83 FR 8311895**

(43) Date de publication de la demande :
**23.01.85 Bulletin 85/04**

(45) Mention de la délivrance du brevet :
**30.09.87 Bulletin 87/40**

(84) Etats contractants désignés :
**DE FR GB IT NL**

(56) Documents cités :
**DE-A- 2 052 112**
**DE-A- 2 811 426**
**DE-A- 2 932 049**

(73) Titulaire : **THOMSON-CSF**
**173, Boulevard Haussmann**
**F-75379 Paris Cédex 08 (FR)**

(72) Inventeur : **Imbert, Michel**
**THOMSON-CSF SCPI 173, bld Haussmann**
**F-75379 Paris Cedex 08 (FR)**
Inventeur : **van den Driessche, Michel**
**THOMSON-CSF SCPI 173, bld Haussmann**
**F-75379 Paris Cedex 08 (FR)**

(74) Mandataire : **Guérin, Michel et al**
**THOMSON-CSF SCPI 19, avenue de Messine**
**F-75008 Paris (FR)**

**Description**

La présente invention concerne le domaine des générateurs de fréquence asservie et elle concerne plus particulièrement un synthétiseur de fréquence utilisable dans un téléviseur.

Dans un téléviseur, on a souvent besoin de plusieurs fréquences bien définies et qui correspondent généralement à des fréquences émises par l'émetteur correspondant. Ce problème se pose plus particulièrement quand on désire fabriquer un téléviseur couleur susceptible de recevoir des signaux télévisés émis selon des normes ou standards distincts.

Actuellement, les standards les plus utilisés de télévision couleur ont en commun que le contenu de chaque ligne de télévision comprend la superposition d'informations de luminance et d'informations de chrominance, ces dernières étant portées par une sous-porteuse de chrominance. Ce contenu d'informations est précédé par un top de synchronisation et une salve de quelques oscillations du signal de la sous-porteuse de chrominance.

Les différents systèmes de télévision couleur diffèrent par la fréquence de la sous-porteuse de chrominance, la façon dont cette sous-porteuse de chrominance est modulée par les informations de chrominance (modulation d'amplitude ou modulation de phase), et la façon dont la phase ou la fréquence de la sous-porteuse de chrominance varie d'une ligne à la suivante.

Dans le système NTSC, la sous-porteuse de chrominance est la même pour toutes les lignes. Sa fréquence est de 3,57 MHz selon les normes américaines. Certains pays européens ont adopté le système NTSC, mais avec une fréquence de sous-porteuse égale à 4,43 MHz.

Dans le système PAL, la fréquence de la sous-porteuse de chrominance est la même pour toutes les lignes, mais la phase d'un des vecteurs de modulation varie de + ou — 90° d'une ligne à l'autre. Usuellement, la fréquence de la sous-porteuse de chrominance est normalisée à 4,43 MHz. Dans ce système, le signal de salve est également déphasé de + ou — 90° d'une ligne à la suivante.

Dans le système SECAM, c'est la fréquence centrale de la sous-porteuse de chrominance qui varie d'une ligne à l'autre, respectivement 4,25 MHz et 4,40 MHz. En SECAM, les sous-porteuses de chrominance sont modulées en fréquence, alors que dans les systèmes NTSC et PAL, la sous-porteuse de chrominance est modulée en amplitude et en phase.

Ainsi, un téléviseur susceptible de recevoir les signaux selon les diverses normes mentionnées précédemment doit contenir des oscillateurs permettant de fournir des fréquences de 3,57 MHz, 4,43 MHz, 4,25 MHz et 4,40 MHz. Ces signaux fournis de façon interne par le téléviseur sont ensuite asservis en phase avec les signaux correspondants de l'émission.

Classiquement, pour fournir des signaux d'horloge, on utilise des oscillateurs dont la fréquence peut être ajustée par une tension, mais qui, déjà au repos, doivent avoir une fréquence très proche de la fréquence recherchée. Dans la pratique, ceci conduit à utiliser des oscillateurs à quartz. Ainsi, si l'on cherche à disposer sur une même puce de circuit intégré un nombre important d'oscillateurs, il sera nécessaire de prévoir un nombre relativement important de bornes d'accès à ce circuit pour y connecter les divers circuits résonateurs à quartz ou circuits LC qui, eux, ne peuvent être intégrés. Or, chacun sait que le prix d'un circuit intégré augmente très rapidement avec le nombre de ses bornes d'accès.

Il a déjà été proposé de synthétiser une fréquence élevée, voisine d'une fréquence de référence élevée, à partir de cette fréquence de référence et d'un deuxième signal de référence de fréquence plus faible éventuellement obtenu par division de la fréquence de référence élevée. Le document DE 2 811 425 montre une telle synthèse ; mais il ne prend pas en compte le fait que la synthèse de fréquence se fait non pas en permanence mais périodiquement (pendant le retour de trame du balayage du téléviseur).

Le synthétiseur de l'invention utilise une référence de fréquence stable et précise, extérieure au circuit. Dans un téléviseur, il existe par ailleurs des circuits qui exigent la présence d'un oscillateur à quartz, par exemple une horloge, un microprocesseur ou des circuits de synthèse de fréquence du tuner (sélection des canaux). L'invention permet d'utiliser simplement cette fréquence de référence pour générer diverses fréquences synthétisées de valeurs également stables.

Pour atteindre cet objet ainsi que d'autres, la présente invention prévoit un synthétiseur d'une fréquence déterminée FO à partir de deux fréquences de référence (FR et FH), cette fréquence déterminée étant telle que |FR-FO| = n FH avec n = N1/N2, N1 et N2 étant des entiers. Ce synthétiseur comprend un oscillateur commandé dont la fréquence libre est voisine de FO ; un premier multiplieur recevant la fréquence de référence FR et la fréquence F fournie par l'oscillateur et fournissant un signal à la fréquence FR-F ; un premier diviseur muni d'une entrée de remise à zéro recevant le signal FR-F et fournissant un signal (FR-F)/N1 ; un deuxième diviseur muni d'une entrée de remise à zéro recevant la deuxième fréquence de référence FH et fournissant un signal à la fréquence FH/N2 ; un circuit recevant les sorties des premier et second diviseurs et fournissant vers l'oscillateur commandé un signal de commande positif ou négatif selon que le signal du premier diviseur est en avance ou en retard sur celui du second ; ledit synthétiseur étant caractérisé en ce qu'il comprend en outre des moyens de validation agissant sur les entrées de remise à zéro des deux diviseurs pour les valider dès que deux impulsions des signaux aux

fréquences |FR-F| et FH apparaissent sensiblement simultanément et jusqu'à ce que les deux sorties des diviseurs soient simultanément à haut niveau.

La deuxième fréquence de référence FH peut être obtenue par division de la première. Néanmoins, dans un téléviseur, elle correspondra de préférence à la fréquence de balayage de lignes.

D'autres aspects de la présente invention ainsi qu'une description détaillée des moyens de validation apparaîtront dans la description suivante faite en relation avec les figures jointes parmi lesquelles :

la figure 1 représente un schéma sous forme de blocs d'un synthétiseur selon la présente invention,

la figure 2 représente les allures des signaux en divers points du circuit de la figure 1,

la figure 3 représente une première application de la présente invention,

la figure 4 représente une deuxième application de la présente invention.

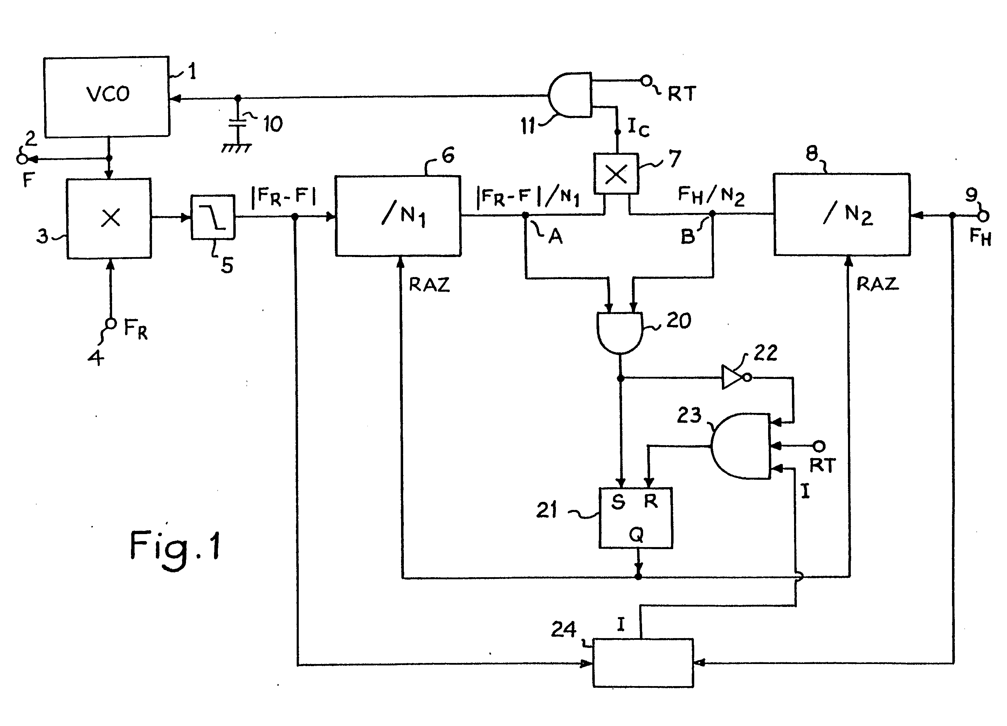

Le circuit selon la présente invention illustré en figure 1 comprend un oscillateur commandé par une tension 1 (du type couramment désigné dans la littérature anglo-saxonne par le sigle VCO). Selon une caractéristique importante de la présente invention, cet oscillateur, qui doit fournir avec l'assistance de l'ensemble du circuit selon l'invention la fréquence que l'on cherche à synthétiser, n'est pas un oscillateur de haute précision à quartz. Cet oscillateur fournit au repos une fréquence F qui tend vers la fréquence FO que l'on cherche à synthétiser et qui est disponible sur une borne 2. Cette borne 2 est connectée à l'entrée d'un multiplieur 3 dont une autre entrée, 4, reçoit un signal de référence à une fréquence FR. Ce multiplieur est suivi d'un filtre passe-bas 5 à la sortie duquel on obtient donc un signal à la fréquence de |FR-F|. Ce signal est transmis à l'entrée d'un premier diviseur 6 effectuant une division par un entier N1 à la sortie A duquel on obtient donc un signal de fréquence |FR-F|/N1. La borne A est connectée à la première entrée d'un détecteur de coïncidence 7. L'autre entrée de ce détecteur 7 reçoit la sortie B d'un diviseur 8 effectuant une division par un entier N2 d'un signal à une fréquence de référence FH apparaissant sur la borne d'entrée de ce diviseur. La sortie du détecteur 7 est transmise à l'entrée de l'oscillateur commandé 1 auquel elle sert de signal d'erreur mémorisé sur un moyen de mémorisation tel qu'un condensateur 10. Eventuellement, la sortie du détecteur 7 passe par l'intermédiaire d'un moyen de validation 11.

D'autre part, un ensemble logique permet le fonctionnement satisfaisant du circuit. Cet ensemble comprend une porte ET 20 dont les entrées sont respectivement connectées aux bornes A et B. La sortie de cette porte ET est transmise, d'une part, à l'entrée S d'une bascule RS 21 et, d'autre part, par l'intermédiaire d'un inverseur logique 22 à la première entrée d'une porte ET 23 dont la sortie est connectée à la borne R de la bascule 21. Une deuxième entrée de la porte ET 23 reçoit un signal de validation RT et la troisième entrée de la porte ET 23 reçoit un signal d'initialisation I provenant d'un détecteur de coïncidence à fenêtre 24 dont la première entrée reçoit le signal |FR-F| disponible à l'entrée du diviseur 6 et dont l'autre entrée reçoit le signal à la fréquence FH disponible à l'entrée de l'autre diviseur 8.

On va décrire ce circuit plus particulièrement dans une application à un téléviseur couleur où la première fréquence de référence FR est la fréquence de la sous-porteuse de chrominance selon les normes PAL de 4,433 MHz, où la fréquence que l'on cherche à synthétiser est la fréquence de la sous-porteuse de chrominance FOB du système SECAM égale à 4,250 MHz et où la deuxième fréquence de référence FH est la fréquence de balayage horizontal ou fréquence de ligne d'un téléviseur 625 lignes qui est égale à 15,625 kHz. En ce cas, FR-FO = 183,6 kHz, ce qui correspond à une période $T_{R-O}$ = 5,45 microsecondes. On a alors FR-FO = 4/47 FH, c'est-à-dire que le système fournit la fréquence FO recherchée quand (FR-F)/47 = FH/4. Dans cette application, le signal de validation appliqué aux portes ET 11 et 23 et désigné dans la figure 1 par la référence RT est le signal de retour de trame. En effet, on ne synthétise la sous-porteuse de chrominance que pendant ce retour de trame.

Pour expliquer le fonctionnement du circuit de la figure 1, on supposera que l'on part d'un état initial où la bascule 21 a sa sortie Q à l'état 1, c'est-à-dire que le dernier signal qu'elle a reçu est un signal sur son entrée S. Dans ce cas, les entrées de remise à zéro des diviseurs 6 et 8 qui reçoivent le signal de sortie de cette bascule inhibent le fonctionnement de ces diviseurs. Ceux-ci ne peuvent fonctionner que si un signal est appliqué à l'entrée R de la bascule 21, ce qui place la sortie Q au niveau O. Pour que cette entrée R reçoive un signal, il faut que les trois entrées de la porte ET 23 se trouvent simultanément à haut niveau. On doit d'abord être dans une période de retour trame pendant laquelle un signal RT à haut niveau est reçu. Comme on a supposé que les diviseurs 6 et 8 étaient inhibés, les sorties A et B de ces diviseurs sont à bas niveau et la sortie de la porte ET 20 est à bas niveau. L'entrée correspondant à la sortie de l'inverseur 22 vers la porte 23 est donc à haut niveau. Il reste donc à recevoir un signal d'initialisation I à haut niveau. Ceci se produit quand le détecteur de coïncidence à fenêtre 24 détecte des impulsions, par exemple des fronts montants des signaux FR-F et FH situés à l'intérieur d'un écart temporel déterminé. A partir de ce moment, les diviseurs N1 et N2 commencent à fonctionner. Un front montant apparaît alors à la borne A au bout de 47 périodes du signal FR-F, c'est-à-dire après une durée égale à 47 $T_{R-O}$ tandis qu'un front montant apparaît à la borne B après une durée de 4 $T_H$ ; le détecteur de coïncidence 7 fournit alors un signal de sortie pendant la durée qui sépare l'apparition de ces deux fronts montants. Dès que le deuxième front montant est apparu, la sortie de la porte ET 20 agit sur l'entrée S de la bascule 21 et les diviseurs 6 et 8 sont à nouveau inhibés jusqu'à ce qu'un signal I suivant apparaisse, du moment que l'on se trouve encore à l'intérieur de la période de retour de trame. On notera que sur l'apparition d'un niveau haut en sortie de la porte ET 20 on vient inhiber tout rétablissement (Reset) de la bascule 21 par l'intermédiaire de la porte 23. On supprime ainsi toute ambiguïté sur la fin du comptage. On notera également que le signal de commande fourni par le détecteur 7 est positif ou négatif selon que la sortie du diviseur 6 est en retard ou en avance par rapport à la sortie du diviseur 8.

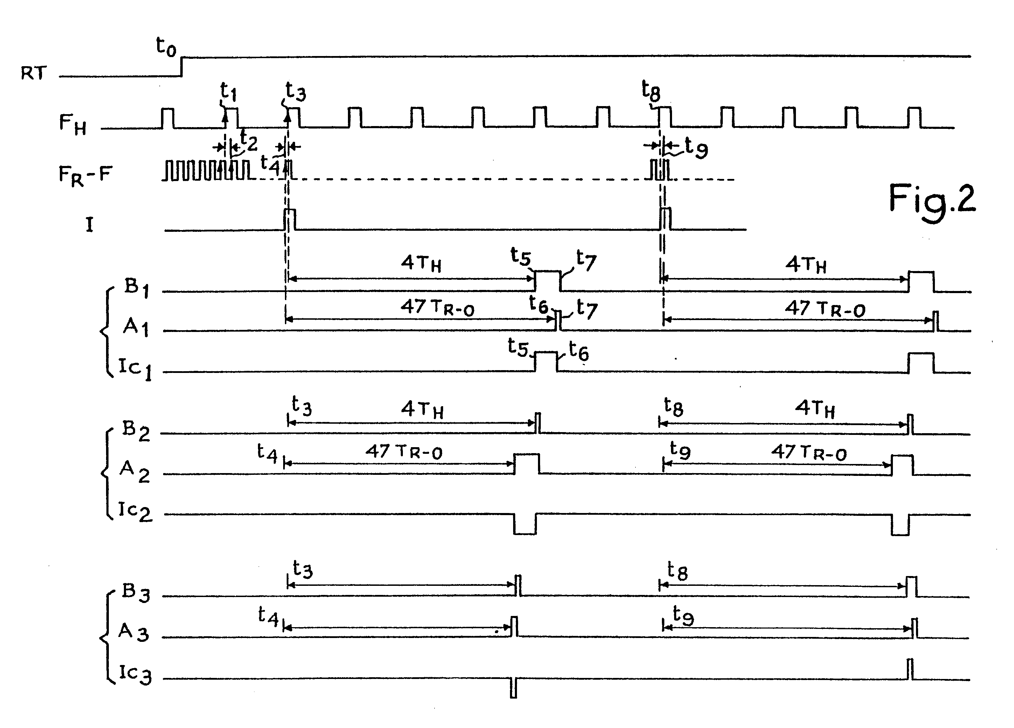

La figure 2 illustre des formes d'ondes en divers points du circuit de la figure 1. En haut de la figure, est représenté le signal de retour de trame RT d'un téléviseur; ce signal est à zéro pendant le balayage de l'image et à haut niveau pendant le retour de trame. Rappelons que la période de balayage est classiquement de 20 ms en Europe et que la durée du retour de trame est de l'ordre de 1,4 ms. A partir de l'instant t0, le système selon l'invention peut fonctionner, les portes ET 11 et 23 recevant un signal de validation.

La deuxième courbe de la figure 2 représente le train d'impulsions FH à l'entrée du diviseur 8 et la troisième courbe le train d'impulsions FR-F à l'entrée du diviseur 6. Dans le cas de l'exemple numérique illustré précédemment, rappelons que FH est égal à 15,625 KHz alors que FR-FO est égal à 183,6 KHz. Ainsi, un nombre important, supérieur à 10, d'impulsions FR-F apparaît dans l'intervalle entre deux impulsions FH.

A l'instant t1, lors de l'apparition de la première impulsion FH après l'instant t0, le détecteur de coïncidence 24 indique que l'écart |t1-t2| entre le front montant de l'impulsion du signal FH et le front montant de l'impulsion la plus proche du signal FR-F est supérieur à la fenêtre déterminée par le détecteur de coïncidence 24. Aucun signal I n'est donc transmis par ce détecteur de coïncidence 24.

Supposons qu'à l'instant t3 d'apparition de l'impulsion de signal FH suivante, l'intervalle de temps t3-t4 entre cette impulsion et l'impulsion la plus proche du signal à la fréquence FR-F est inférieur à la fenêtre déterminée par le détecteur de coïncidence 24. Alors, apparaît un signal d'initialisation I comme cela est représenté dans la figure. La porte ET 23 valide alors la bascule 21 et les diviseurs 6 et 8 fonctionnent. Le diviseur 8 fournit un signal à haut niveau à partir d'un instant t5 (voir courbe B1) distant de l'instant t3 d'une distance égale à quatre périodes du signal à la fréquence FH, soit $4T_H$. Le diviseur 6 fournit lui à sa sortie A un signal à haut niveau à un instant t6 (voir courbe A1) distant de 47 périodes du signal à la fréquence FR-F, soit $47T_{R-O}$. A partir de l'instant t6, la porte ET 20 reçoit deux entrées à haut niveau et la bascule 21 commute à l'état 1 ce qui inhibe le fonctionnement des diviseurs 6 et 8 et ramène très rapidement, à un instant t7 très voisin de l'instant t6 les signaux A et B à bas niveau. Pendant la durée s'étendant des instants t5 à t7, le détecteur de coïncidence 7 fournit un signal de commande IC (voir courbe IC1) vers l'oscillateur commandé 1, ce signal étant sensiblement nul entre les instants t6 et t7 puisque le détecteur 7 effectue la différence entre les deux signaux incidents. On notera que la durée d'intervalle t5-t6 est d'autant plus grande que le désaccord de la fréquence F de l'oscillateur commandé 1 est important par rapport à la fréquence FO recherchée. Après l'instant t7, le détecteur de coïncidence 24 recherche la coïncidence ou quasi-coïncidence suivante des signaux aux fréquences FH et FR-F, quasi-coïncidence qui apparaît pour les instants t8 et t9 indiqués sur la figure.

On notera que si des coïncidences avaient été détectées par hasard entre les instants t3 et t8, une impulsion I non représentée sur la figure pourrait apparaître mais cette impulsion n'aurait aucun effet sur le déroulement des opérations indiquées précédemment.

L'ensemble de courbes B2, A2, IC2 indique le cas où le décalage de fréquence de l'oscillateur commandé par rapport à la fréquence souhaitée est en sens inverse du cas illustré précédemment, c'est-à-dire que la durée $47T_{R-O}$ est inférieure à $4T_H$ au lieu d'être supérieure à $4T_H$. Alors, apparaît une impulsion de commande IC2 de polarité inverse de celle indiquée précédemment.

Enfin, l'ensemble de courbes B3, A3, IC3 indique le cas où la fréquence de l'oscillateur commandé se rapproche de la fréquence FO souhaitée. En ce cas, la largeur des impulsions de commande est sensiblement nulle du fait que $4T_H$ = $47T_{R-O}$. Il apparaît néanmoins un petit signal d'erreur, aléatoirement positif ou négatif selon que, comme cela apparaît sur la figure, les décalages t3-t4 et t8-t9 sont positifs ou négatifs.

Calcul d'erreurs.

On peut apprécier la précision obtenue pour la fréquence FO en effectuant un calcul d'erreurs basé sur des valeurs numériques réalistes.

Une première erreur est celle due au temps de propagation dans les diviseurs. On peut rendre ces temps de propagation sensiblement égaux en introduisant des retards appropriés et, si le diviseur par 47 comprend par exemple 18 opérateurs élémentaires présentant chacun une erreur aléatoire de 10 nanosecondes, l'erreur d'ensemble sera de 180 nanosecondes et une erreur équivalente existe pour l'autre diviseur et son système de compensation. On aura donc une erreur possible dT de l'ordre de + ou — 400 nanosecondes. L'erreur de fréquence sera alors de l'ordre de :
$dF_1$ = (FR-FO) × $dT/2T_H$, soit 183,6 kHz × 0,4/128 = + ou — 0,6 kHz.

Une deuxième erreur est due à la largeur de la fenêtre de détection du détecteur de coïncidence 24. Si l'on choisit une fenêtre d'une largeur égale au quart de la période $T_{R-O}$, soit environ 5,45/4 = 1,4 ms, l'erreur dF correspondante sera $dF_2$ = (FR-FO) × 1,4 ns/(2 × 64 ms) = 2 kHz.

Cette erreur variera de 0 à + 2 kHz, mais, contrairement à ce qui a été exposé dans la description précédente, elle peut être choisie pour être toujours dans le même sens. D'autre part, elle peut être partiellement compensée pour arriver à une valeur de + ou — 200 Hz.

Une troisième erreur est celle due à l'oscillateur commandé lui-même et aux pertes dans le condensateur de mémorisation 10. En supposant que le courant de fuite dans ce condensateur soit de 0,5 microampère et que le courant de commande IC puisse avoir une valeur maximale de 10 milliampères, si l'on considère qu'il peut y avoir trois échantillonnages par période de retour trame qui est de 1,4 ms pour une durée de trame de 20 ms, la largeur d'impulsions T sera telle que :

$$(20 - 1,4) \text{ IE} = 3 \cdot T \times IC,$$
$$\text{soit } T = 0,32 \text{ ms,}$$

ce qui donne une erreur de fréquence $dF_3 = 220$ Hz.

L'erreur totale sera donc de 600 + 200 + 220 Hz, soit environ 1 000 Hz (1kHz). Il s'agit là d'une erreur tout à fait minime pour un signal recherché d'une fréquence de 4,250 MHz. On peut donc même élargir la fenêtre du détecteur de coïncidence pour la porter à une valeur égale à celle de la période de FR-FO, ce qui quadruple l'erreur liée à l'impulsion d'initialisation et augmente seulement de 600 Hz l'erreur totale.

Exemples d'application.

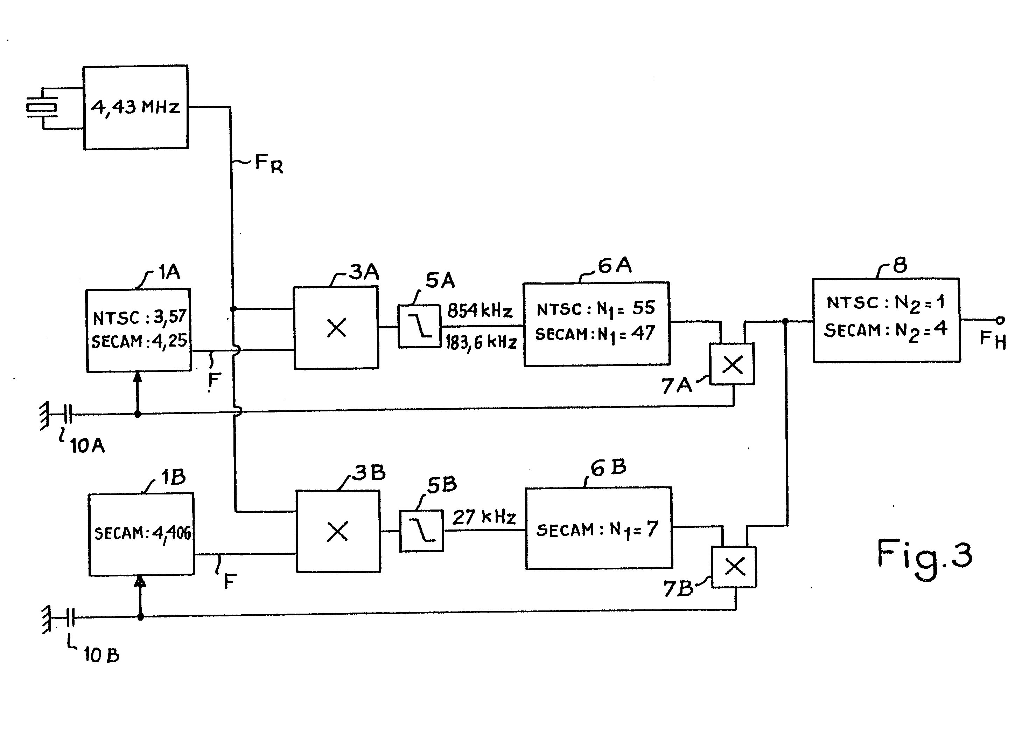

La figure 3 représente une application de la présente invention dans laquelle on génère toute une série de fréquences de référence à partir de la fréquence de référence fournie par un oscillateur à quartz asservi sur la fréquence de référence du système PAL égal à 4,43 MHz. Comme cela est représenté sur la figure, on peut ainsi générer la fréquence de base du système NTSC qui est de 3,57 MHz ou les fréquences de base du système SECAM de 4,25 et 4,406 MHz. Des valeurs numériques ont été indiquées précédemment pour obtenir la valeur de référence de 4,25 MHz. Pour obtenir la valeur de référence de 3,57 MHz, il convient de prévoir pour le diviseur 6 une valeur N1 = 55 et pour le diviseur 8 une valeur N2 = 1. Pour la fréquence de 4,406 MHz, il convient de prévoir pour le diviseur 6 une valeur N1 = 7 et pour le diviseur 8 la même valeur N2 = 4 que pour le cas de l'autre fréquence de référence du système SECAM.

Comme l'indique la figure 3, étant donné que l'on n'a pas besoin simultanément des fréquences de référence NTSC et SECAM, il est possible d'utiliser un seul ensemble de diviseurs par exemple pour la fréquence de référence à 4,25 MHz du SECAM et la fréquence de référence à 3,57 MHz du NTSC. Des moyens de conditionnement sont prévus pour modifier le facteur de division de ce diviseur. De même, le facteur de division du diviseur-8 sera modifié pour passer de 4 à 1 selon que l'on cherche à obtenir la fréquence de référence du SECAM ou du NTSC.

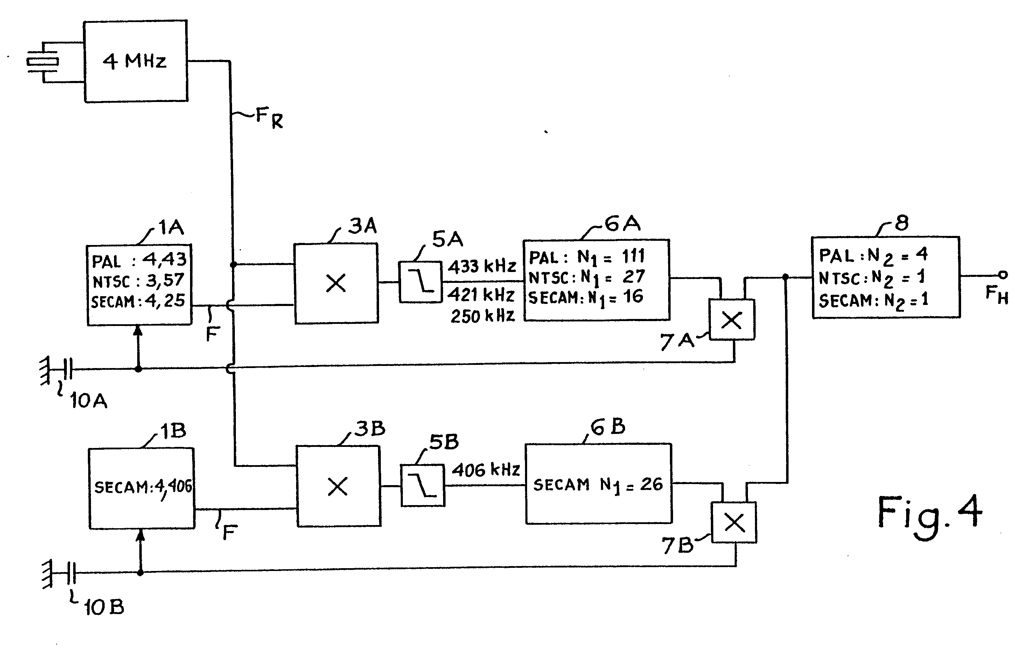

La figure 4 indique de même comment à partir d'une fréquence de référence arbitraire de 4 MHz, on peut générer toutes les fréquences souhaitées à condition de choisir des valeurs convenables pour les facteurs de division N1 et N2. Pour obtenir la fréquence de référence du PAL à 4,43 MHz, le diviseur par N1 (6A) effectue une division par 111 et le diviseur par N2 (8) une division par 4. Pour fournir un signal de référence NTSC à 3,57 MHz, le diviseur par N1 (6A) effectue une division par 27 tandis que le diviseur par N2 effectue une division par l'unité. Pour fournir la fréquence de référence SECAM du bleu à 4,25 MHz, le diviseur par N1 (6A) effectue une division par 16 tandis que le diviseur par N2 (8) effectue une division par l'unité. Enfin, pour obtenir la fréquence de référence SECAM à 4,406 MHz, le diviseur par N1 (6B) (distinct du diviseur 6A puisque les deux signaux SECAM doivent être disponibles simultanément) effectue une division par 26 alors que le diviseur par N2 (8) effectue toujours une division par l'unité. Bien entendu, des moyens de commutation sont prévus pour modifier l'oscillateur commandé 1A et le diviseur par N1 6A selon que l'on souhaite obtenir un signal de fréquence de référence à 4,43, 3,57 ou 4,25 MHz.

De même, en figures 3 et 4, on n'a pas représenté les ensembles de circuits logiques destinés à assurer le bon fonctionnement du système, ces ensembles étant analogues à ceux décrits précédemment en relation avec la figure 1.

**Revendications**

1. Synthétiseur d'une fréquence déterminée (FO) à partir de deux fréquences de référence (FR et FH), cette fréquence déterminée étant telle que |FR-FO| = n FH avec n = N1/N2, N1 et N2 étant des entiers positifs, comprenant

un oscillateur commandé dont la fréquence libre F est voisine de FO :

un premier multiplieur (3) recevant FR et F et fournissant la fréquence FR-F,

un premier diviseur (6) muni d'une entrée de remise à zéro recevant la fréquence FR-F et fournissant la fréquence FR-F/N1,

un deuxième diviseur (8) muni d'une entrée de remise à zéro recevant la fréquence FH et fournissant la fréquence FH/N2,

un premier détecteur de coïncidence (7) recevant les sorties des premier et deuxième diviseurs et fournissant vers l'oscillateur commandé (1) un signal de commande positif ou négatif selon que le signal du premier diviseur est en avance ou en retard sur celui du second,

caractérisé en ce qu'il comprend en outre des moyens de validation (20 à 24) agissant sur les entrées de remise à zéro des deux diviseurs pour les valider dès que deux impulsions des signaux aux fréquences |FR-F| et FH apparaissent sensiblement simultanément et jusqu'à ce que les sorties des deux diviseurs soient simultanément à haut niveau.

2. Synthétiseur selon la revendication 1, caractérisé en ce que les moyens de validation comprennent un second détecteur de coïncidence (24) fournissant un signal quand l'écart entre des fronts déterminés, de montée ou de descente, des signaux d'entrée des diviseurs est inférieur à un seuil déterminé.

3. Synthétiseur selon la revendication 1, caractérisé en ce que la deuxième fréquence de référence est obtenue par division de la première.

4. Synthétiseur selon la revendication 1, caractérisé en ce que les moyens de validation valident les diviseurs pendant les retours de trame du balayage du téléviseur.

## Claims

1. A frequency synthesizer for synthesizing a frequency (FO) which is determined on the basis of two reference frequencies (FR and FH) and which is determined such that $|FR-FO| = n \cdot FH$, n being N1/N2 and N1 and N2 being positive integers, comprising
a controlled oscillator, the free frequency F of which is close to FO,
a first multiplier (3) receiving FR and F and supplying the frequency FR-F,
a first divider (6), whose return to zero input receives the frequency FR-F and which supplies the frequency FR-F/N1,
a second divider (8) whose return to zero input receives the frequency FH and which supplies the frequency FH/N2,
a first coincidence detector (7) receiving the output signals of the first and second dividers and supplying to the controlled oscillator (1) a control signal of positive or negative polarity according to whether the output signal of the first divider preceeds the output signal of the second divider or vice versa,
characterized in that it further comprises validation means (20 to 24) acting on the return to zero inputs of both dividers in order to validate them whenever two pulses of the signals at the frequencies |FR-F| and FH appear substantially at the same moment, the validation lasting until the outputs of the two dividers show simultaneously a high level.

2. A synthesizer according to claim 1, characterized in that the validation means include a second coincidence detector (24) supplying a signal whenever the interval between predetermined edges, the leading or the sloping edge, of the divider input signals is below a predetermined threshold value.

3. A synthesizer according to claim 1, characterized in that the second reference frequency is obtained by dividing the first one.

4. A synthesizer according to claim 1, characterized in that the validation means validate the dividers during the frame return intervals of the scanning of the television set.

## Patentansprüche

1. Frequenzsynthetisierer, dessen Frequenz (FO) ausgehend von zwei Bezugsfrequenzen (FR und FH) bestimmt ist, wobei diese bestimmte Frequenz so gewählt ist, daß gilt $|FR-FO| = n \cdot FH$, wobei n = N1/N2 und N1 sowie N2 positive ganze Zahlen sind,
mit einem gesteuerten Oszillator, dessen freie Frequenz F in der Nähe von FO liegt,
mit einem ersten Multiplizierer (3), der FR und F empfängt und die Frequenz FR-F liefert,
einen ersten Teiler (6), dessen Nullsetzungseingang die Frequenz FR-F zugeführt erhält und der die Frequenz FR-F/N1 liefert,
mit einem zweiten Teiler (8), dessen Nullsetzungseingang die Frequenz FH zugeführt erhält und der die Frequenz FH/N2 liefert,
mit einem ersten Koinzidenzdetektor (7), der die Ausgangssignale des ersten und des zweiten Teilers zugeführt erhält und an den gesteuerten Oszillator (1) ein positives oder negatives Steuersignal liefert, je nachdem, ob das Signal des ersten Teilers dem des zweiten Teilers voreilt oder nacheilt,
dadurch gekennzeichnet, daß er außerdem Bewertungsmittel (20 bis 24) aufweist, die auf die Nullsetzungseingänge der beiden Teiler einwirken, um sie zu aktivieren, sobald die beiden Impulse der Signale mit den Frequenzen |FR-F| und FH im wesentlichen simultan auftreten, und zwar solange, bis die Ausgänge der beiden Teiler gleichzeitig einen hohen Pegel anzeigen.

2. Synthetisierer nach Anspruch 1, dadurch gekennzeichnet, daß die Bewertungsmittel einen zweiten Koinzidenzdetektor (24) aufweisen, der ein Signal liefert, wenn der Abstand zwischen bestimmten Flanken, nämlich Ansteigs- oder Abfallflanke, der Eingangssignale der Teiler geringer als ein vorgegebener Schwellenwert ist.

3. Synthetisierer nach Anspruch 1, dadurch gekennzeichnet, daß die zweiten Bezugsfrequenz durch Unterteilung der ersten erhalten wird.

4. Synthetisierer nach Anspruch 1, dadurch gekennzeichnet, daß die Bewertungsmittel die Teiler während des Bildrücklaufs des Abtaststrahls des Fernsehgeräts aktivieren.

Fig.1

Fig.2

Fig.3

Fig. 4